(19) **Europäisches Patentamt / European Patent Office / Office européen des brevets**

(11) **EP 3 346 534 B1**

(12) **FASCICULE DE BREVET EUROPEEN**

(45) Date de publication et mention de la délivrance du brevet:
**14.08.2019   Bulletin 2019/33**

(51) Int Cl.:
*H01M 8/04298* (2016.01)   *H01M 8/0432* (2016.01)
*H01M 8/04438* (2016.01)   *H01M 8/04537* (2016.01)
*H01M 8/04223* (2016.01)   *H01M 8/0444* (2016.01)
*H01M 8/04492* (2016.01)

(21) Numéro de dépôt: **18150601.5**

(22) Date de dépôt: **08.01.2018**

(54) **PROCEDE ET DISPOSITIF D OBSERVATION D'UN ETAT D'UN SYSTEME ELECTROCHIMIQUE A PILE A COMBUSTIBLE**

VERFAHREN UND VORRICHTUNG ZUM BEOBACHTEN EINES ZUSTANDS EINES ELEKTROCHEMISCHEN SYSTEMS MIT BRENNSTOFFZELLE

METHOD AND DEVICE FOR OBSERVING A STATE OF AN ELECTROCHEMICAL SYSTEM WITH A FUEL CELL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **09.01.2017   FR 1750165**

(43) Date de publication de la demande:
**11.07.2018   Bulletin 2018/28**

(73) Titulaire: **COMMISSARIAT À L'ÉNERGIE ATOMIQUE ET AUX ÉNERGIES ALTERNATIVES**
**75015 Paris (FR)**

(72) Inventeurs:
 • **PIFFARD, Maxime**
   **38100 GRENOBLE (FR)**
 • **BIDEAUX, Eric**
   **69621 VILLEURBANNE Cedex (FR)**
 • **GERARD, Mathias**
   **38100 GRENOBLE (FR)**
 • **MASSIONI, Paolo**
   **69100 VILLEURBANNE (FR)**
 • **NAIFF DA FONSECA, Ramon**
   **38000 GRENOBLE (FR)**

(74) Mandataire: **GIE Innovation Competence Group**
   **310, avenue Berthelot**
   **69372 Lyon Cedex 08 (FR)**

(56) Documents cités:
   **US-A1- 2008 081 235**

 • JIXIN CHEN ET AL: "Optimization of purge cycle for dead-ended anode fuel cell operation", INTERNATIONAL JOURNAL OF HYDROGEN ENERGY., vol. 38, no. 12, 1 avril 2013 (2013-04-01) , pages 5092-5105, XP055392109, GB ISSN: 0360-3199, DOI: 10.1016/j.ijhydene.2013.02.022
 • CHEN YONG-SONG ET AL: "Implementation and evaluation for anode purging of a fuel cell based on nitrogen concentration", APPLIED ENERGY, vol. 113, 4 octobre 2013 (2013-10-04), pages 1519-1524, XP028763069, ISSN: 0306-2619, DOI: 10.1016/J.APENERGY.2013.09.028
 • MAXIME PIFFARD ET AL: "Control by state observer of PEMFC anodic purges in dead-end operating mode", IFAC-PAPERSONLINE, vol. 48, no. 15, 1 janvier 2015 (2015-01-01), pages 237-243, XP055391591, ISSN: 2405-8963, DOI: 10.1016/j.ifacol.2015.10.034
 • CHRISTOPHE ROBIN ET AL: "Development and experimental validation of a PEM fuel cell 2D-model to study heterogeneities effects along large-area cell surface", INTERNATIONAL JOURNAL OF HYDROGEN ENERGY., vol. 40, no. 32, 7 juillet 2015 (2015-07-07), pages 10211-10230, XP055237638, GB ISSN: 0360-3199, DOI: 10.1016/j.ijhydene.2015.05.178

EP 3 346 534 B1

**Description**

**DOMAINE TECHNIQUE**

La présente invention concerne un procédé et un dispositif d'observation d'un système électrochimique comportant une pile à combustible. Elle concerne également un système de commande incluant un tel procédé et dispositif d'observation, adapté à commander la purge du circuit de distribution anodique de la pile à combustible.

**ÉTAT DE LA TECHNIQUE ANTÉRIEURE**

Une pile à combustible est formée d'un empilement de cellules électrochimiques, comportant chacune une anode et une cathode séparées électriquement l'une de l'autre par un électrolyte, dans lesquelles a lieu une réaction électrochimique entre deux réactifs qui sont introduits de manière continue. Dans le cas d'une pile à hydrogène, le combustible (l'hydrogène) est apporté au contact de l'anode, alors que le comburant (l'oxygène) par exemple contenu dans de l'air, est amené au contact de la cathode. La réaction est subdivisée en deux demi-réactions, une oxydation et une réduction, qui ont lieu l'une à l'interface anode/électrolyte et l'autre à l'interface cathode/électrolyte. Elle requiert la présence d'un conducteur ionique entre les deux électrodes, à savoir l'électrolyte, et un conducteur électronique formé par le circuit électrique externe. L'empilement de cellules est le lieu de la réaction électrochimique : les réactifs doivent y être apportés, les produits et les espèces non réactives doivent en être évacués, ainsi que la chaleur produite.

En sortie de pile, deux configurations se rencontrent habituellement. Dans un premier cas correspondant à un fonctionnement dit en mode ouvert, les sorties d'anode et de cathode communiquent avec un conduit d'évacuation des fluides. Ainsi, lorsqu'on alimente la pile en sur-stoechiométrie (rapport entre la quantité de réactif injecté et la quantité de réactif consommé supérieur à 1), le gaz sortant présente un débit suffisant pour évacuer l'eau produite par la réaction, qui peut ensuite être collectée à l'aide d'un séparateur de phase. Pour éviter de perdre le réactif non consommé, un dispositif de recirculation est habituellement prévu, qui réinjecte le réactif non consommé en entrée de pile. Cependant, du fait de la recirculation fluidique, les espèces non réactives, tel que l'azote à l'anode dans le cas d'une alimentation en air à la cathode, voient leur concentration molaire augmenter progressivement, ce qui nécessite d'effectuer régulièrement une étape de purge de la cellule.

Dans un deuxième cas correspondant à un fonctionnement dit en mode bouché (*dead end*, en anglais), la sortie de l'anode est obturée, ainsi que, le cas échéant, celle de la cathode, et la pile est alimentée en réactifs avec un rapport stoechiométrique sensiblement égal à 1, en particulier en ce qui concerne l'hydrogène. Ainsi, la quantité d'hydrogène introduit à l'anode correspond à la quantité consommée lors de la réaction. Dans ce cas, les espèces non réactives et l'eau liquide produite ne sont pas évacuées, ce qui conduit à une augmentation progressive de leur concentration molaire du côté anodique de la cellule. Il est alors nécessaire de procéder régulièrement à une étape de purge de la cellule, pour en évacuer les espèces non réactives et l'eau liquide.

Dans les deux cas, il peut être utile de connaître les valeurs de paramètres tels que la quantité d'azote et d'eau à l'anode, pour commander l'ouverture d'une vanne de purge reliée au circuit de distribution anodique. Cependant, ces paramètres ne sont pas toujours directement mesurables ou ne sont pas mesurables en temps réel. Aussi, sur la base d'une représentation d'état du système électrochimique à pile à combustible, il est possible d'estimer un état du système électrochimique, dont les variables d'état comportent la quantité d'azote et/ou d'eau à l'anode, à partir d'un vecteur de commande et d'un vecteur de mesure dont les composantes sont des paramètres mesurables du système. Un tel dispositif d'observation, ou observateur d'état, forme donc un capteur logiciel du système électrochimique.

La publication de Piffard et al, intitulée Control by state observer of PEMFC anodic purges in dead-end operating mode, IFAC-PapersOnLine, 48-15 (2015) 237-243, décrit un exemple de dispositif d'observation adapté à fournir une estimation d'un état d'un système électrochimique dont la pile à combustible fonctionne en mode *dead-end*. A partir de la valeur estimée de la variable d'état représentative de la quantité d'azote à l'anode, la purge du circuit de distribution anodique est alors commandée.

Le dispositif d'observation reçoit un vecteur de commande U tel que $U = [Q_{ao}; T; I]$, dont les termes sont un signal de purge $Q_{ao}$ correspondant à l'ouverture ($Q_{ao}=1$) et à la fermeture ($Q_{ao}=0$) de la vanne de purge, une mesure d'une température T d'un fluide caloporteur du circuit de refroidissement, et une mesure du courant électrique I fourni par la pile à combustible. Il reçoit également un vecteur de mesure Y tel que $Y = [R_m]$, dont l'unique terme est une valeur de la résistance ohmique $R_m$ de la membrane électrolytique. A partir des vecteurs de commande U et de mesure Y, il fournit une estimation d'un état X tel que $X = \left[ n_{N_2}^a ; n_{H_2O}^a ; n_{H_2O}^c ; \lambda_m \right]$, dont les variables d'état sont représentatives d'une quantité d'azote à l'anode $n_{N_2}^a$, des quantités d'eau à l'anode $n_{H_2O}^a$ et à la cathode $n_{H_2O}^c$, et d'une quantité

d'eau $\lambda_m$ dans la membrane. L'estimation d'état est fournie en utilisant un filtre de Kalman dit « unscented » (UKF, pour *Unscented Kalman Filter*, en anglais).

Cependant, le dispositif d'observation présente notamment l'inconvénient d'avoir recours à des hypothèses contraignantes sur l'évolution temporelle de la pression et de la température au sein de la pile à combustible, ces hypothèses étant nécessaires au réglage de l'algorithme UKF.

Le document "optimization of purge cycle for dead-ended anode fuel cell opération" International Journal of Hydrogen Energy, vol. 38, 2013, pages 5092-5105, décrit un procédé d'observation d'une pile à combustible afin d'optimiser le cycle de purge.

## EXPOSÉ DE L'INVENTION

L'invention a pour objectif de remédier au moins en partie aux inconvénients de l'art antérieur, et plus particulièrement de proposer un procédé d'observation d'un état d'un système électrochimique comportant une pile à combustible formée d'au moins une cellule électrochimique comprenant une anode et une cathode séparée l'une de l'autre par une membrane, comportant en outre un circuit de distribution anodique d'hydrogène relié à une ligne fluidique d'évacuation anodique munie d'une vanne de purge commandée à partir d'un signal dit de purge, et un circuit de distribution cathodique en oxygène.

Le procédé comporte les étapes suivantes :

a) mesure, à un instant de mesure, d'un courant électrique de la pile à combustible, d'une tension électrique de la pile à combustible, d'une pression dite anodique du circuit de distribution anodique, d'une pression dite cathodique du circuit de distribution cathodique, et d'une température de la pile à combustible ;

b) formation d'un vecteur de commande à partir du signal de purge et des mesures du courant électrique, de la température et de la pression cathodique ;

c) formation d'un vecteur de mesure à partir d'une valeur de résistance ohmique de la membrane déduite des mesures du courant électrique et de la tension électrique, et à partir de la mesure de la pression anodique ;

d) calcul d'une évolution temporelle dite non corrigée, à partir d'une estimation préalable de l'état et du vecteur de commande, sur la base d'une représentation d'état prédéterminée du système électrochimique, l'état étant formé de variables d'état représentatives des quantités d'azote et d'hydrogène à l'anode, et des quantités d'eau à l'anode, à la cathode, et dans la membrane ;

e) calcul d'un terme correcteur en mode glissant à partir d'un écart entre le vecteur de mesure et une estimation dite de mesure du vecteur de mesure obtenue à partir d'une estimation préalable de l'état ;

f) calcul d'une estimation dudit état du système électrochimique pour l'instant de mesure, à partir de l'évolution temporelle non corrigée et du terme correcteur ;

g) réitération des étapes a) à f) en incrémentant l'instant de mesure, l'estimation préalable des étapes d) et e) correspondant alors à l'estimation d'état calculée à l'itération précédente.

Certains aspects préférés mais non limitatifs de ce procédé d'observation sont les suivants.

L'écart peut être égal à la différence entre le vecteur de mesure et l'estimation de mesure.

L'estimation de mesure peut être calculée à partir de l'estimation d'état calculée à l'instant de mesure précédent, sur la base d'un modèle prédéterminé exprimant une relation entre le vecteur de mesure, l'état et le vecteur de commande.

Le terme correcteur peut être égal au produit d'un paramètre de gain prédéterminé avec une fonction signe appliquée à l'écart.

Le vecteur d'état peut être défini tel que $X = \left[ n_{N_2}^a ; n_{H_2O}^a ; n_{H_2O}^c ; \lambda_m ; n_{H_2}^a \right]$, le vecteur de commande peut être défini tel que $U = [Q_{ao}; I; T; P^c]$, et le vecteur de mesure peut être défini tel que $Y = [R_m; P^a]$.

L'étape f) de calcul de l'estimation d'état peut comporter une étape de calcul d'un terme dit d'évolution d'estimation d'état dont les termes s'écrivent :

$$\begin{cases} \dot{\hat{x}}_1 = f_1\left(\hat{x}, u\right) - \sigma_1.sign(s_2) \\ \dot{\hat{x}}_2 = f_2\left(\hat{x}, u\right) - \sigma_2.sign(s_2) \\ \dot{\hat{x}}_3 = f_3\left(\hat{x}, u\right) - \sigma_3.sign(s_1) \\ \dot{\hat{x}}_4 = f_4\left(\hat{x}, u\right) - \sigma_4.sign(s_1) \\ \dot{\hat{x}}_5 = f_5\left(\hat{x}, u\right) - \sigma_5.sign(s_2) \end{cases}$$

où $f_{i=1\text{-}5}$ sont les termes de ladite représentation d'état, $\sigma_{i=1\text{-}5}$ sont les termes d'un paramètre de gain, et $s_{i=1,2}$ sont les termes dudit écart définis par $s_1 = y_1 - \hat{y}_1$ et $s_2 = y_2 - \hat{y}_2$, où $y_1$ et $y_2$ sont les termes du vecteur de mesure, et où $\hat{y}_1$ et $\hat{y}_2$ sont les termes de l'estimation de mesure.

Le paramètre de gain peut être déterminé de manière à vérifier les fonctions $\dot{V}_1 = s_1\dot{s}_1 < 0$ et $\dot{V}_2 = s_2\dot{s}_2 < 0$.

L'invention porte également sur un dispositif d'un état d'un système électrochimique comportant une pile à combustible formée d'au moins une cellule électrochimique comprenant une anode et une cathode séparée l'une de l'autre par une membrane, comportant en outre un circuit de distribution anodique d'hydrogène relié à une ligne fluidique d'évacuation anodique munie d'une vanne de purge commandée à partir d'un signal dit de purge, et un circuit de distribution cathodique en oxygène, le dispositif d'observation comportant :

- des capteurs adaptés à fournir, pour des instants de mesure successifs, des mesures mesure d'un courant électrique de la pile à combustible, d'une tension électrique de la pile à combustible, d'une pression dite anodique du circuit de distribution anodique, d'une pression dite cathodique du circuit de distribution cathodique, et d'une température de la pile à combustible ;
- un calculateur configuré pour mettre en oeuvre le procédé d'observation selon l'une quelconque des caractéristiques précédentes à chaque instant de mesure.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

la figure 1 est une vue schématique et partielle d'un système électrochimique à pile à combustible, connecté à un dispositif d'observation du système électrochimique selon un mode de réalisation, comportant un ensemble de capteurs de mesure et un calculateur adapté à fournir une estimation d'un état du système électrochimique à partir des mesures des capteurs ;

la figure 2A est un organigramme illustrant les étapes de calcul mises en oeuvre par un procédé d'observation selon un mode de réalisation, et la figure 2B est un organigramme qui détaille les étapes de calcul du terme correcteur ;

la figure 3 est une vue schématique et partielle du système électrochimique et du dispositif d'observation selon le mode de réalisation ;

les figures 4A à 4C sont des exemples de l'évolution temporelle de l'humidité relative à l'anode (fig.4A) et à la cathode (fig.4B), et de l'évolution temporelle de la fraction volumique d'azote à l'anode (fig.4C) dans le cadre d'un fonctionnement d'un système électrochimique dont la purge du circuit de distribution anodique est commandée à partir de l'estimation d'état fournie par le dispositif d'observation.

## EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près.

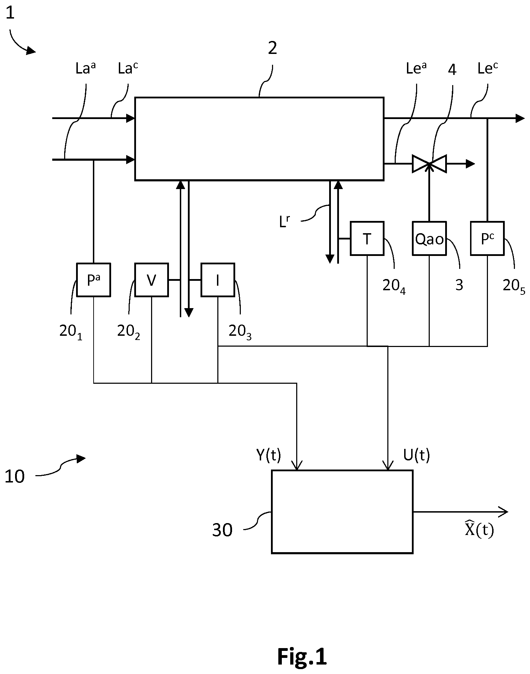

La figure 1 illustre de manière schématique un système électrochimique 1 à pile à combustible 2, équipé de capteurs de mesure 20 d'un dispositif d'observation 10 selon un mode de réalisation. Le dispositif d'observation 10 est adapté à fournir une estimation d'un état X du système électrochimique 1.

Le système électrochimique 1 comporte une pile à combustible 2 et un dispositif de purge 3 du circuit d'évacuation anodique de la pile à combustible 2. On considérera ici en particulier une pile à hydrogène, celle-ci étant alimentée en hydrogène côté anode et en air contenant de l'oxygène côté cathode. Cependant, l'invention s'applique à tout type de pile à combustible, en particulier à celles fonctionnant à basse température, c'est-à-dire à une température inférieure à 250 °C.

La pile à combustible 2 comporte au moins une cellule électrochimique, et de préférence un empilement de cellules électrochimiques. Chaque cellule comporte une anode et une cathode séparées l'une de l'autre par une membrane électrolytique, cet ensemble formant un assemblage membrane électrodes (AME). L'anode, la membrane et la cathode sont des éléments classiques connus de l'homme du métier et ne sont donc pas décrites en détail. Chaque assemblage est séparé de celui des cellules adjacentes par des plaques bipolaires, adaptées à amener les espèces réactives à l'anode d'une première cellule d'une part et à la cathode d'une cellule adjacente d'autre part, et à évacuer les produits issus des réactions électrochimiques et les espèces non réactives, ainsi qu'à transmettre le courant électrique entre les cellules. Elle peut également assurer l'écoulement d'un fluide caloporteur entre les cellules de manière à permettre l'évacuation de la chaleur produite.

La pile à combustible 2 comporte un circuit de distribution anodique adapté à amener l'hydrogène à l'anode des cellules électrochimiques, qui s'étend entre un collecteur d'entrée et un collecteur de sortie. De la même manière, il comporte un circuit de distribution cathodique adapté à amener l'oxygène à la cathode des cellules électrochimiques, qui s'étend entre un collecteur d'entrée et un collecteur de sortie. Ainsi, les collecteurs d'entrée anodique et cathodique sont adaptés à assurer l'injection fluidique des gaz d'alimentation jusqu'aux cellules électrochimiques, et les collecteurs de sortie sont adaptés à évacuer les gaz d'alimentation non réagis et des espèces non réactives hors des cellules électrochimiques et de la pile à combustible. Les circuits de distribution anodique et cathodique sont alimentés en gaz réactifs par des lignes fluidiques d'alimentations $La^a$, $La^c$ reliées aux collecteurs d'entrée, et des lignes fluidiques d'évacuation $Le^a$, $Le^c$ sont reliées aux collecteurs de sortie.

La pile à combustible comporte en outre un circuit de refroidissement qui s'étend au niveau des cellules électrochimiques. Le circuit de refroidissement est adapté à faire circuler un fluide caloporteur destiné à évacuer la chaleur produite au cours de la réaction électrochimique hors de la pile à combustible. Le circuit de refroidissement est relié à des lignes fluidiques de refroidissement $L^r$ adaptées à injecter et évacuer le fluide caloporteur vis-à-vis du circuit de refroidissement.

Le système électrochimique 1 comporte également un dispositif de purge 3 du circuit de distribution anodique. Pour cela, il comporte une vanne de purge 4 disposée ici sur la ligne d'évacuation anodique $Le^a$ pour permettre la purge momentanée des fluides qui peuvent s'accumuler dans le circuit de distribution anodique. Ainsi, la vanne de purge 4 est à ouverture commandée, c'est-à-dire que son ouverture et sa fermeture sont commandées à partir d'un signal de commande Qao. Dans cet exemple, la pile à combustible 2 fonctionne en mode bouché (*dead-end*) mais elle pourrait également fonctionner en mode à recirculation.

Le dispositif d'observation 10 est adapté à fournir une estimation X(t) en temps réel d'un état X(t) du système électrochimique 1 à partir d'informations fournies par un vecteur de commande U(t) et un vecteur de mesure Y(t).

Pour cela, le dispositif d'observation 10 comporte des capteurs 20 adaptés à fournir des signaux représentatifs de paramètres d'excitation et/ou de réponse associée au fonctionnement du système électrochimique 1, dont les valeurs permettent de former les vecteurs de commande U(t) et de mesure Y(t) du dispositif d'observation 10. Il est également connecté électriquement au dispositif de commande 3 de la vanne de purge 4 pour recevoir le signal de commande $Q_{ao}$. Le signal de commande $Q_{ao}$ prend dans cet exemple une valeur égale à l'unité en cas de purge du circuit anodique, et une valeur nulle lorsque la vanne de purge 4 est fermée. En variante, le signal $Q_{ao}$ peut prendre une valeur comprise entre 0 et 1, traduisant le degré d'ouverture de la vanne de purge.

Ainsi, le dispositif d'observation comporte un capteur de pression $20_1$ adapté à fournir une mesure en temps réel d'une pression anodique $P^a$ du gaz circulant dans le circuit de distribution anodique. A titre d'exemple, la mesure peut être effectuée au niveau du collecteur d'entrée ou de sortie du circuit de distribution anodique. Il comporte également un capteur de tension $20_2$ adapté à fournir en temps réel une mesure de la tension électrique V de la pile à combustible, ainsi qu'un capteur de courant $20_3$ adapté à fournir en temps réel une mesure du courant électrique I fourni par la pile à combustible 2 en réponse à la demande d'une charge électrique. Le dispositif d'observation comporte en outre un moyen de calcul (non représenté) pour calculer une valeur d'une résistance ohmique $R_m$ de la membrane électrolytique, à partir des valeurs mesurées du courant électrique I et de la tension électrique V. La valeur de la résistance ohmique Rm déduite à partir des mesures du courant électrique I et de la tension électrique V, ainsi que la valeur mesurée de la pression anodique $P^a$ forment les paramètres du vecteur de mesure Y(t).

Le dispositif d'observation 10 comporte également un capteur de température $20_4$ adapté à fournir une mesure en temps réel d'une température T de la pile à combustible, par exemple une température du fluide caloporteur circulant dans le circuit de refroidissement. A titre illustratif, la température T peut être mesurée à la sortie du circuit de refroidissement. Il comporte un capteur de pression $20_5$ adapté à fournir une mesure en temps réel d'une pression cathodique

$P^c$ du gaz circulant dans le circuit de distribution cathodique. A titre d'exemple, la mesure peut être effectuée au niveau du collecteur d'entrée ou de sortie du circuit cathodique. Le signal de commande $Q_{ao}$, la mesure du courant électrique I, la mesure de la température de refroidissement T, et la mesure de la pression cathodique $P^c$ forment les paramètres du vecteur de commande U(t). Les valeurs mesurées des paramètres des vecteurs de commande et de mesure varient dans le temps.

Le dispositif d'observation comporte un calculateur 30 adapté à fournir en temps réel l'estimation X(t) de l'état X(t) du système électrochimique à partir du vecteur de commande U(t) et du vecteur de mesure Y(t).

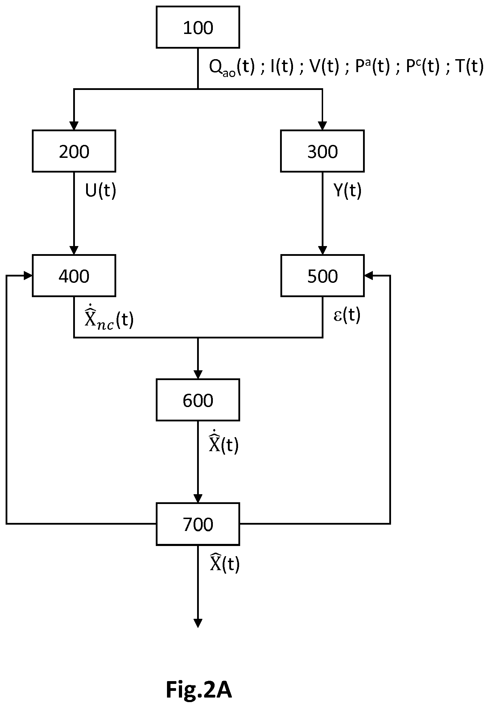

La figure 2A illustre un organigramme d'un procédé d'observation selon le mode de réalisation. Le procédé repose ici sur un observateur d'état de la classe des observateurs à mode glissant. Il est adapté à fournir en temps réel une estimation X(t) d'un état X(t) du système électrochimique 1 à partir d'informations fournies par un vecteur de commande U(t) et un vecteur de mesure Y(t), et sur la base d'un modèle dynamique du système, appelé représentation d'état, exprimant l'évolution temporelle X(t) de l'état X(t), en tenant compte d'un terme correcteur en mode glissant.

Plus précisément, les étapes du procédé d'observation sont effectuées à des instants de mesure tk successifs. Le temps est discrétisé selon un pas d'échantillonnage temporel $\Delta$t. Les étapes du procédé sont réitérées à chaque incrémentation k+1 de l'instant de mesure. Dans la suite de la description, les notations X(t), U(t), Y(t)...s'entendent comme les valeurs des vecteurs X, U, Y... à l'instant de mesure considéré.

La représentation d'état du système électrochimique 1 est définie par le système d'équations (1) suivant :

$$\begin{cases} \dot{X}=f(X,U) \\ Y=h(X,U) \end{cases} \qquad (1)$$

où f est la fonction d'état et h est la fonction d'observation.

L'observateur en mode glissant du système électrochimique 1 est défini par le système d'équations (2) suivant :

$$\begin{cases} \dot{\hat{X}}=f(\hat{X},U)-K.sign(S) \qquad (2) \\ \hat{Y}=h(\hat{X},U) \end{cases}$$

où K est un paramètre de gain et où S est un terme appelé surface de glissement, qui est de préférence défini comme l'écart entre l'estimation $\hat{Y}$ et le vecteur de mesure Y: $S = Y - \hat{Y}$. Ainsi, l'observateur comporte un terme dit correcteur, c'est-à-dire K.sign(S), qui permet d'assurer la minimisation de l'écart S entre l'estimation $\hat{Y}$ et le vecteur de mesure Y, et ainsi d'établir la convergence de l'estimation $\hat{X}$ vers un état supposé réel X.

Lors d'une étape 100, le dispositif d'observation 10 mesure, à l'instant de mesure tk, les valeurs du signal de purge $Q_{ao}$, du courant électrique I et de la tension électrique V de la pile à combustible, de la pression anodique $P^a$ et de la pression cathodique $P^c$, et de la température T du fluide caloporteur.

Lors d'une étape 200, le vecteur de commande U, de dimension 4, est formé, pour l'instant de mesure tk, à partir des paramètres représentatifs du signal de purge $Q_{ao}$, du courant électrique mesuré I, de la température mesurée T, et de la pression cathodique mesurée $P^c$. Ainsi, le vecteur de commande U s'écrit : $U = [Q_{ao}; I; T; P^C]$ où $Q_{ao}$ est, dans cet exemple, une valeur égale à 1 ou 0 selon qu'il y a ouverture ou fermeture de la vanne de purge.

Lors d'une étape 300, le vecteur de mesure Y, de dimension 2, est formé, pour l'instant de mesure tk, à partir de paramètres représentatifs de la résistance ohmique Rm de la membrane électrolytique et de la pression anodique $P^a$. Ainsi, le vecteur de mesure Y peut s'écrire : $Y = [R_m; P^a]$ où $R_m$ est la valeur de la résistance ohmique de la membrane, déduite à partir de la valeur du courant électrique I mesurée par le capteur de courant et de la valeur de la tension électrique V mesurée par le capteur de tension.

Une telle formation des vecteurs de commande U et de mesure Y permet d'observer un état X, de dimension 5, pour l'instant de mesure tk, comportant des variables d'état représentatives d'une quantité d'azote à l'anode, d'une quantité d'eau à l'anode, à la cathode et dans la membrane, et d'une quantité d'hydrogène à l'anode. Ainsi, le vecteur d'état peut s'écrire : $X = \left[ n_{N_2}^a ; n_{H_2O}^a ; n_{H_2O}^c ; \lambda_m ; n_{H_2}^a \right]$ où $n_{N2}^a$ est le nombre de moles d'azote dans le circuit anodique, $n_{H2O}^a$ et $n_{H2O}^c$ est le nombre de moles d'eau, en phase liquide et gazeuse, respectivement dans le circuit anodique et le circuit cathodique, $\lambda_m$ est le nombre de moles d'eau dans la membrane électrolytique, et où $n_{H2}^a$ est le nombre de moles d'hydrogène dans le circuit anodique.

En d'autres termes, les vecteurs de commande U(t), de mesure Y(t), et d'état X(t) s'écrivent :

$$U = \begin{bmatrix} Q_{ao} \\ I \\ T \\ P^c \end{bmatrix} \quad Y = \begin{bmatrix} R_m \\ P^a \end{bmatrix} \quad X = \begin{bmatrix} n_{N_2}^a \\ n_{H_2O}^a \\ n_{H_2O}^c \\ \lambda_m \\ n_{N_2}^a \end{bmatrix} \tag{3}$$

Lors d'une étape 400, une évolution temporelle dite non corrigée $\dot{X}_{nc}$ de l'estimation X de l'état X est calculée, pour l'instant de mesure tk, à partir du vecteur de commande U et d'une estimation préalable $\hat{X}$, sur la base de la fonction d'observation f mentionnée précédemment, formalisée ici à partir d'un modèle décrit dans la publication de Robin et al intitulée Development and experimental validation of a PEM fuel cell2D-model to study heterogeneities effects along large-area cell surface, Int. J. Hydrogen Energy, 40 (2015) 10211-10230, et exprimée par le système d'équations suivant :

$$\begin{cases} \dot{x}_1 = f_1(x,u) \\ \dot{x}_2 = f_2(x,u) \\ \dot{x}_3 = f_3(x,u) \\ \dot{x}_4 = f_4(x,u) \\ \dot{x}_5 = f_5(x,u) \end{cases} \Leftrightarrow \begin{cases} \dot{n}_{N_2}^a = K_{N_2} - F_{P,N_2} \\ \dot{n}_{H_2O}^a = F_d^a - F_{eo} - F_{P,H_2O} \\ \dot{n}_{H_2O}^c = F_d^c + F_{eo} + I/2F + F_{in} - F_{out} \\ \dot{\lambda}_m = EW/\rho_d e_m S \left( -F_d^a - F_d^c \right) \\ \dot{n}_{H_2}^a = F_{in,H_2} - I/2F - F_{P,H_2} \end{cases} \tag{4}$$

où les paramètres suivants sont notamment définis dans la publication de Robin 2015 :

- $K_{N_2}$ est le flux de perméation d'azote de la cathode à l'anode au travers de la membrane, qui dépend notamment des variables d'état $\lambda_m$ et $n_{N_2}^a$, et des variables de commande $T$ et $P^c$ ;
- $F_{P,X}$ est le flux de purge de l'espèce X à la sortie du circuit de distribution anodique, qui dépend notamment des variables d'état $n_{N_2}^a$, $n_{H_2}^a$ et $n_{H_2O}^a$, et de la variable de commande $Q_{ao}$ ;
- $F_d^a$ et $F_d^c$ sont les flux de diffusion de l'eau au travers de la membrane, respectivement à l'anode et à la cathode, qui dépendent notamment des variables d'état $\lambda_m$ et respectivement de $n_{H_2O}^a$ ou $n_{H_2O}^c$, et de la variable de commande $T$ ;
- $F_{eo}$ est le flux électroosmotique d'eau au travers de la membrane, qui dépend notamment de la variable d'état $\lambda_m$ et de la variable de commande $I$ ;
- $F_{in}$ et $F_{out}$ sont respectivement les flux d'eau entrant et sortant dans le circuit de distribution cathodique, qui dépendent notamment des variables de commande $I, T, P^c$ ;
- $F_{in,H_2}$ est le flux d'hydrogène entrant dans le circuit de distribution cathodique, qui dépend notamment des variables d'état $n_{N_2}^a$, $n_{H_2}^a$ et $n_{H_2O}^a$, et de la variable de commande $T$ ;
- $F$ est la constante de Faraday, $EW$ est le poids équivalent de la membrane, $\rho_d$ est la densité de la membrane électrolytique sèche, $e_m$ et $S$ sont l'épaisseur et la surface de la membrane.

L'estimation d'état préalable $\hat{X}$ peut être égale, lors de la première itération temporelle $t_{k=1}$, c'est-à-dire lors de l'initialisation du procédé d'observation, à des valeurs initiales prédéfinies du vecteur d'état $X(t_{k=0})$. Lors des itérations temporelles suivantes tk, l'estimation d'état préalable X correspond à la valeur calculée lors de l'étape 700 à l'instant

de mesure précédent $t_{k-1}$.

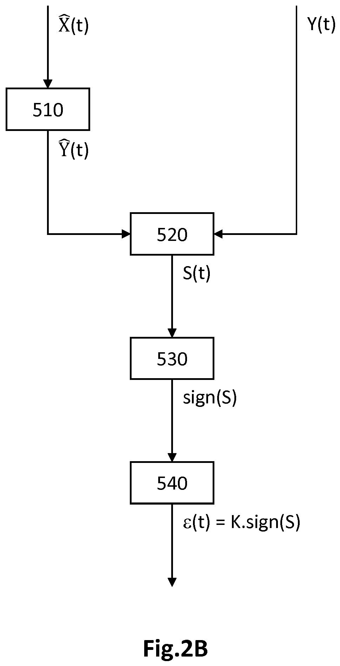

Lors d'une étape 500, le terme correcteur $\varepsilon$ en mode glissant est calculé, pour l'instant de mesure tk, à partir du vecteur de mesure Y défini lors de l'étape 300 et à partir de la même valeur d'estimation d'état préalable X, calculée à l'instant de mesure précédent tk-1, que pour l'étape 400. Il présente une formulation en mode glissant, c'est-à-dire qu'il est égal à K.sign(S), où K est un paramètre de gain prédéterminé, où sign(.) est la fonction discontinue signe, et où S est une surface de glissement calculée à partir d'un écart entre le vecteur de mesure Yet une estimation dite de mesure $\hat{Y}$ du vecteur de mesure Y. Cette étape est détaillée par la suite, en référence à la figure 2B.

Lors d'une étape 600, une évolution temporelle $\dot{\hat{X}}$ est calculée pour l'instant de mesure tk à partir de l'évolution temporelle non corrigée $\dot{\hat{X}}_{nc}$ et du terme correcteur $\varepsilon$, ici par différence entre $\dot{\hat{X}}_{nc}$ et $\varepsilon$.

Lors d'une étape 700, l'estimation X du vecteur d'état X est calculée, pour l'instant de mesure tk, par intégration temporelle de l'évolution temporelle $\dot{\hat{X}}$ obtenue à l'étape 600.

Le procédé d'observation comporte la réitération temporelle successive des étapes 100 à 700, par incrémentation de l'instant de mesure tk, de manière à fournir en temps réel l'estimation d'état X(t) à partir des vecteurs actualisés de commande U(t) et de mesure Y(t). La valeur de l'estimation d'état $\hat{X}(t)$ calculée à l'étape préalable 700 lors d'une itération temporelle tk est prise en compte lors de l'itération temporelle suivante $t_{k+1}$ comme estimation d'état préalable' pour les étapes 400 et 500. Le procédé d'observation comporte ainsi deux boucles fermées qui tiennent chacune compte de la valeur de l'estimation $\hat{X}(t)$ calculée lors de l'étape 700 préalable, l'une associée au calcul de l'évolution temporelle non corrigée et l'autre associée au terme correcteur. Ainsi, la minimisation de l'écart S(t) entre l'estimation de mesure $\hat{Y}(t)$ et le vecteur de mesure Y(t) a lieu progressivement dans le temps. A ce titre, comme il est décrit plus loin, le paramètre de gain K est prédéterminé de sorte que la convergence soit atteinte en un temps fini plus ou moins contraint.

Ainsi, pour l'état X(t) défini précédemment, la formation des vecteurs de commande U(t) et de mesure Y(t) à partir du signal de purge et des mesures des capteurs permet d'assurer l'observabilité du système électrochimique 1, c'est-à-dire le fait que le dispositif d'observation 10 est en mesure de fournir une estimation X(t) de l'état X(t) pour tout intervalle de temps $[t_i; t_f]$ à partir des informations fournies par les vecteurs de commande U(t) et de mesure Y(t).

De plus, il apparaît qu'au moins une variable du vecteur de mesure Y(t), à savoir ici la pression anodique Pa, dépend notamment des variables d'état $n_{N_2}^a$ et $n_{H_2}^a$ représentatives de la quantité d'azote et d'hydrogène dans le circuit anodique. Ainsi, le dispositif d'observation, permet d'observer effectivement les variables d'état $n_{N_2}^a$ et $n_{H_2}^a$. C'est également le cas pour la variable d'état $n_{H_2O}^a$ dans la mesure où la pression anodique Pa dépend notamment de $n_{H_2O}^a$.

Par observer, on entend que les variables d'état estimées $n_{N_2}^a$ et $n_{H_2}^a$ convergent effectivement vers les valeurs que l'on suppose réelles, du fait de la correction en mode glissant qui minimise l'écart entre l'estimation $\hat{Y}$ et le vecteur de mesure Y.

Le procédé d'observation présente en outre l'avantage de ne pas nécessiter l'utilisation de capteurs d'humidité pour fournir les mesures de quantité d'eau dans les circuits de distribution anodique et cathodique. Il permet en outre de fournir en temps réel l'estimation X de l'état X sans avoir recours à des hypothèses contraignantes sur la variation temporelle en pression et en température de la pile à combustible.

La figure 2B illustre en détail l'étape 500 de calcul du terme correcteur $\varepsilon$ en mode glissant du procédé d'observation illustré sur la figure 2A.

Lors d'une étape 510, l'estimation $\hat{Y}$ est calculée, pour l'instant de mesure tk, à partir d'une estimation préalable X de l'état X, sur la base de la fonction d'observation h prédéterminée exprimée ici par le système d'équations suivant :

$$\begin{cases} y_1 = h_1(\hat{x}, u) \\ y_2 = h_2(\hat{x}, u) \end{cases} \Leftrightarrow \begin{cases} R_m = \dfrac{e_m}{S} \dfrac{1}{33,75\lambda_m - 21,41} e^{1268/T} \\ P^a = \left( n_{N_2}^a + n_{H_2}^a + n_{H_2O}^a \right) RT/V \end{cases} \qquad (5)$$

Comme mentionné précédemment, l'estimation d'état préalable $\hat{X}$ peut correspondre, lors de la première itération temporelle $t_{k=1}$, c'est-à-dire lors de l'initialisation du procédé d'observation, à des valeurs initiales prédéfinies du vecteur d'état $X(t_{k=0})$. Lors des itérations temporelles suivantes, l'estimation d'état préalable X correspond à la valeur calculée lors de l'étape 700 à l'instant de mesure $t_{k-1}$ précédent.

Lors d'une étape 520, on calcule, pour l'instant de mesure tk, une surface de glissement S définie comme la différence entre l'estimation $\hat{Y}$ et le vecteur de mesure Y, telle que :

$$\begin{cases} s_1 = y_1 - \hat{y}_1 \\ s_2 = y_2 - \hat{y}_2 \end{cases} \tag{6}$$

Lors d'une étape 530, on calcule, pour l'instant de mesure tk, la fonction signe de la surface de glissement S, définie de sorte qu'elle est égale à 1 lorsque S est positive, nulle lorsque S est nulle et égale à -1 lorsque S est négative.

Lors d'une étape 540, on calcule, pour l'instant de mesure tk, le terme correcteur ε = K.sign(S) tel que :

$$\begin{cases} \varepsilon_1 = \sigma_1 sign(s_2) \\ \varepsilon_2 = \sigma_2 sign(s_2) \\ \varepsilon_3 = \sigma_3 sign(s_1) \\ \varepsilon_4 = \sigma_4 sign(s_1) \\ \varepsilon_5 = \sigma_5 sign(s_2) \end{cases} \tag{7}$$

où les termes $\varepsilon_i$ sont les termes correcteurs, $\sigma_i$ sont les termes du paramètre de gain K. Le terme $s_2$ de la surface de glissement est associée uniquement aux termes $\varepsilon_1$, $\varepsilon_2$ et $\varepsilon_5$, et donc aux variables d'état $x_1$, $x_2$ et $x_5$, dans la mesure où ces variables $s_2$ et $\varepsilon_1$, $\varepsilon_2$ et $\varepsilon_5$ sont relatives à l'anode.

On multiplie ainsi la fonction signe appliquée à la surface de glissement S par le paramètre de gain K. Les termes du gain sont prédéterminés de manière à assurer la convergence du système sur la surface de glissement S. Pour cela, on définit deux fonctions dites de Lyapunov :

$$\begin{cases} V_1 = \frac{1}{2}\left(s_1\right)^2 \\ V_2 = \frac{1}{2}\left(s_2\right)^2 \end{cases} \tag{8}$$

En supposant que $\dfrac{\dot{\lambda}_m}{\lambda_m} \gg \dfrac{\dot{T}_m}{T_m}$, c'est-à-dire en supposant que la dynamique (évolution temporelle) associée à la quantité d'eau dans la membrane est plus rapide que celle associée à la température de la membrane, l'évolution temporelle $\dot{V}_1$ et $\dot{V}_2$ des fonctions de Lyapunov, ici les dérivées premières des termes $V_1$ et $V_2$ par rapport au temps, peuvent s'écrivent :

$$\begin{cases} \dot{V}_1 = s_1\left( \dot{y}_1 - \dfrac{dh_1(\hat{x})}{d\hat{x}_4}f_4\left(\hat{x},u\right) + \dfrac{dh_1(\hat{x})}{d\hat{x}_4}\sigma_4 sign(s_1) \right) \\ \dot{V}_2 = s_2\left( \dot{y}_2 - \dfrac{RT}{V_a}\sum_{k=1,2,5} f_k\left(\hat{x},u\right) + \dfrac{RT}{V_a}\sum_{k=1,2,5}\sigma_k sign(s_2) \right) \end{cases} \tag{9}$$

La convergence du système suppose que les évolutions temporelles $\dot{V}_1$ et $\dot{V}_2$ soient négatives, c'est-à-dire que $\dot{V}_1 = s_1\dot{s}_1 < 0$ et $\dot{V}_2 = s_2\dot{s}_2 < 0$, ce qui se traduit par les conditions suivantes sur les différents termes du paramètre de gain K :

$$\begin{cases} \sigma_4 > \max \left| \frac{\dot{y}_1}{dh_1(\hat{x})/d\hat{x}_4} - f_4(\hat{x},u) \right| \\ \sum_{k=1,2,5} \sigma_k > \max \left| \frac{\dot{y}_2}{RT/V_a} - \sum_{k=1,2,5} f_k(\hat{x},u) \right| \end{cases} \qquad (10)$$

Il apparaît que les termes $\sigma_1$, $\sigma_2$ et $\sigma_5$ du paramètre de gain K n'ont pas à être réglés individuellement, du moment que leur somme respecte la condition ci-dessus. Seul le terme $\sigma_4$ respecte de préférence le critère ci-dessus.

En variante, les conditions de convergence sur les termes du paramètre de gain K peuvent être plus contraignantes, par exemple en définissant que les évolutions temporelles relatives $\dot{V}_1/V_1$ et $\dot{V}_2/V_2$ sont strictement négatives, voire inférieures ou égales à une valeur négative non nulle.

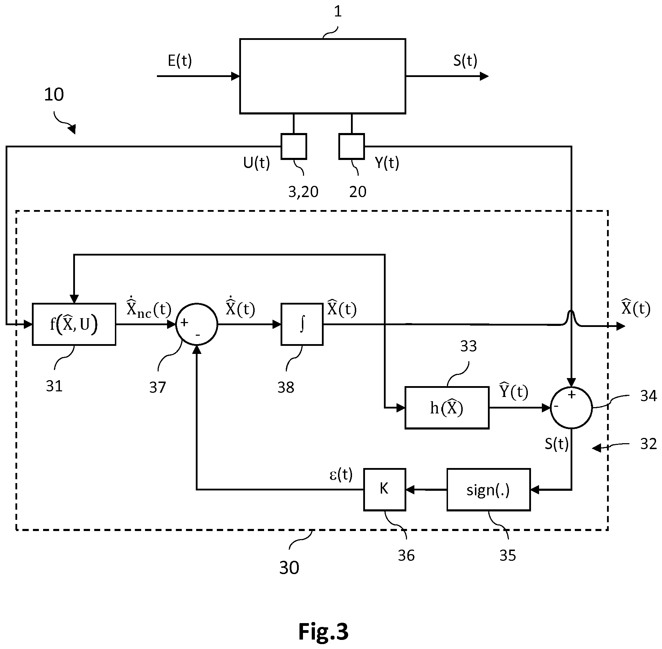

La figure 3 illustre un exemple de structure du dispositif d'observation 10 du système électrochimique 1. Le système électrochimique 1 est soumis à des excitations fluidiques et électrochimiques E(t) et réagit dynamiquement sous la forme d'une réponse S(t).

Le dispositif d'observation 10 comporte les capteurs 20 adaptés à fournir, pour chaque instant de mesure tk, des mesures du courant électrique I, de la tension électrique V, d'une température T du fluide caloporteur, d'une pression anodique $P^a$ et d'une pression cathodique $P^c$. Il est également adapté à recevoir le signal $Q_{ao}$ émis par le dispositif de purge 3.

Il comporte également un calculateur 30 formé de moyens logiciels classiques, tel qu'un processeur, des mémoires vives et/ou mortes, bus de transmission de données numériques etc.., dans lequel est implémenté une fonction d'état f et une fonction d'observation h, ainsi qu'un algorithme d'observation en mode glissant (système d'équations (2) mentionné plus haut).

Le calculateur comporte un module dit d'évolution 31 dans lequel est implémentée la fonction d'état f de la représentation d'état. Ce module d'évolution 31 est adapté à calculer, pour chaque instant de mesure $t_k$, l'évolution temporelle dite non corrigée $\dot{\hat{X}}_{nc}$ de l'estimation d'état $\hat{X}$, en tenant compte du vecteur de commande U et d'une estimation préalable $\hat{X}$, par exemple l'estimation calculée lors de l'étape 700 à l'itération temporelle précédente $t_{k-1}$.

Le dispositif d'observation 10 comporte également un module dit de correction 32 adapté à fournir, pour chaque instant de mesure $t_k$, le terme correcteur $\varepsilon(t)$, exprimé en mode glissant, permettant de minimiser l'écart S(t) entre le vecteur de mesure $Y$ et l'estimation de mesure $\hat{Y}$. Le terme correcteur $\varepsilon(t)$ est dit de mode glissant dans la mesure où il présente une formulation du type K.sign(S) où K est le paramètre de gain et S la surface de glissement.

Le module de correction 32 comporte un sous-module 33 de calcul de l'estimation $\hat{Y}$ dans lequel est implémentée la fonction d'observation h. Il est adapté à calculer l'estimation $\hat{Y}$ à partir d'une estimation préalable $\hat{X}$, par exemple l'estimation calculée lors de l'étape 700 à l'itération temporelle précédente $t_{k-1}$.

Il comporte un comparateur 34 adapté à calculer, pour chaque instant de mesure $t_k$, la surface de glissement S(t) comme différence entre le vecteur de mesure Y(t) reçu des capteurs et l'estimation de mesure $\hat{Y}$ reçue du sous-module 33.

Il comporte un sous-module 35 d'application de la fonction signe à la surface de glissement S(t). La valeur de sign(S(t)) est ensuite multipliée à une matrice de gain K, dont les termes ont été prédéterminés initialement par le sous-module 36, de manière à assurer la convergence du système sur la surface de glissement S(t). On obtient ainsi le terme correcteur $\varepsilon(t)$. La matrice de gain K présente ainsi des valeurs fixes dans le temps.

Le calculateur 30 comporte un comparateur 37 qui calcule, pour chaque instant de mesure tk, l'évolution temporelle $\dot{\hat{X}}(t)$ comme différence entre l'évolution temporelle non corrigée $\dot{\hat{X}}_{nc}$ et le terme correcteur $\varepsilon(t)$. L'évolution temporelle $\dot{\hat{X}}(t)$ obtenue est ensuite intégrée temporellement par l'intégrateur 38 pour fournir l'estimation d'état $\hat{X}(t)$ du système électrochimique 1 à l'instant de mesure $t_k$.

La convergence du dispositif d'observation 10 est assurée progressivement dans le temps, par le biais des deux boucles fermées, dans la mesure où l'estimation d'état $\hat{X}(t)$ calculée lors d'une itération temporelle est transmise en entrée du module de correction 32 d'une part, et en entrée du module d'évolution 31 d'autre part, pour l'itération temporelle suivante.

Il est avantageux que le dispositif de purge 3 soit connecté au dispositif d'observation 10. En fonction des estimations des variables d'état représentatives de la quantité d'azote $n_{N_2}^a$ et/ou d'hydrogène $n_{H_2}^a$ et/ou d'eau $n_{H_2O}^a$ dans le circuit de distribution anodique, lorsque ces valeurs estimées atteignent des valeurs maximales prédéfinies, le dispositif de purge 3 peut assurer l'ouverture de la vanne de purge jusqu'à ce que les valeurs estimées deviennent inférieures aux valeurs maximales, voire jusqu'à ce que les valeurs estimées deviennent sensiblement égales à des valeurs minimales prédéfinies. Cela est d'autant plus possible que le dispositif d'observation 10 fournit l'estimation d'état $\hat{X}(t)$ en temps réel. Il est ainsi possible de commander la purge du circuit de distribution anodique pour éviter que les quantités d'azote, d'hydrogène et/ou d'eau ne provoquent une dégradation des performances électrochimiques de la pile à combustible.

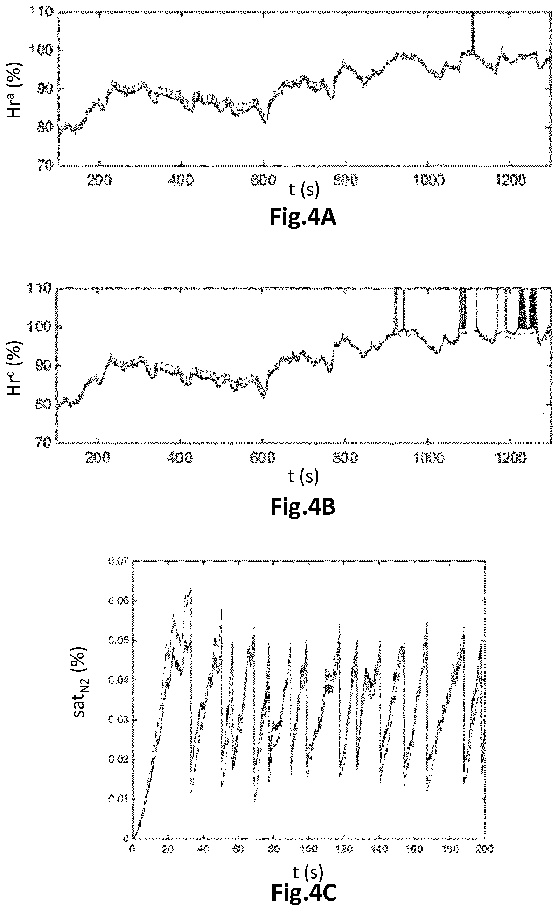

Les figures 4A à 4C illustrent l'évolution temporelle de l'humidité relative à l'anode HR$^a$ (fig.4A), à la cathode HR$^c$ (fig.4B), ainsi que l'évolution temporelle de la saturation d'azote à l'anode (fig.4C), dans le cas d'une commande de purge du circuit de distribution anodique d'une pile à combustible de type PEM fonctionnant en mode *dead-end.* L'ouverture de la vanne de purge est effectuée lorsque la quantité d'azote à l'anode atteint une valeur maximale prédéterminée. Les paramètres d'humidité relative et de saturation d'azote sont déduits des valeurs d'état de l'estimation $\hat{X}(t)$ fournie par le procédé et dispositif d'observation décrit précédemment.

Ces évolutions temporelles obtenues par le procédé et dispositif d'observation selon le mode de réalisation (en trait plein) sont comparées à un modèle physique de référence (en trait pointillé) présenté dans la publication de Robin 2015 mentionnée précédemment.

Le courant électrique I fourni par la pile à combustible est déduit de la puissance électrique demandée par une charge électrique, la puissance électrique étant définie par la 'procédure d'essai mondiale harmonisée pour les voitures particulières et véhicules utilitaires légers' (WLTP, pour *Worldwide harmonized Light vehicles Test Procedures,* en anglais). L'humidité relative est fixée à 0% à l'entrée du circuit de distribution anodique et à 50% à l'entrée du circuit de distribution cathodique. La stoechiométrie d'oxygène est fixée à 2 à la cathode. Celle d'hydrogène est fixée à 1 à l'anode, en cohérence avec le fonctionnement en *dead-end* de la pile à combustible. La température du fluide caloporteur est aléatoire suivant une loi normale gaussienne de moyenne 353K et de variante $10^2$ K, échantillonnée toutes les 10s, avec une variation limitée à plus ou moins 7K par seconde. La pression cathodique P$^c$ et la pression anodique P$^a$ sont aléatoires suivant une loi normale gaussienne de moyenne $2.10^5$ Pa et de variante $(4.10^4)^2$ Pa, échantillonnées toutes les secondes, avec une variation limitée à plus ou moins $10^4$Pa/s.

Dans cet exemple, le terme $\sigma_4$ du paramètre de gain K est fixé à 110 pour respecter la condition déterminée précédemment, et les termes $\sigma_1$, $\sigma_2$ et $\sigma_5$ sont respectivement fixés à 0,06, 0,00 et 0,06, pour que leur somme respecte la condition déterminée précédemment. Le terme $\sigma_3$ est fixé 0.

Comme l'illustre la figure 4C, lorsque la vanne de purge est fermée ($Q_{ao}=0$), la saturation d'azote à l'anode tend à augmenter par diffusion au travers de la membrane, jusqu'à atteindre la valeur maximale prédéterminée, ici de l'ordre de 0,05%. Lorsqu'elle atteint la valeur maximale, le signal de purge $Q_{ao}$ devient égal à 1 et la vanne de purge est ouverte. La saturation d'azote à l'anode chute alors, jusqu'à la fermeture de la vanne de purge. Le signal se poursuit ainsi au cours du temps. Il apparaît ainsi que cette variable déduite de l'estimation $\hat{X}(t)$ fournie par le dispositif d'observation est en accord avec l'évolution de la même variable fournie par le modèle de Robin 20 15. L'évolution des humidités relatives à l'anode et à la cathode, déduites des variables d'état $n_{H_2O}^a$ et $n_{H_2O}^c$ estimées par le dispositif d'observation (fig.4A et 4B), montre également un bon accord avec celle donnée par le modèle de référence de Robin 20 15.

Des modes de réalisation particuliers viennent d'être décrits. Différentes variantes et modifications apparaîtront à l'homme du métier.

Le procédé et le dispositif d'observation décrits précédemment s'appliquent aussi bien au fonctionnement d'une pile à combustible en mode *dead-end* qu'en mode à recirculation. Dans ce cas, le collecteur de sortie anodique est relié au collecteur d'entrée anodique par une boucle de recirculation. L'ouverture d'une vanne de purge est commandée en fonction d'au moins l'une des variables de l'état X du système électrochimique.

La fonction d'état f et la fonction d'observation h sont ici basées sur un modèle physique dynamique du système électrochimique décrit notamment dans l'article de Robin 2015 mentionné précédemment. Elles peuvent être modifiées selon les connaissances de l'homme du métier, en fonction des caractéristiques de la pile à combustible observée, voire être basées sur d'autres modèles électrochimiques.

## Revendications

1. Procédé d'observation d'un état (X) d'un système électrochimique (1) comportant une pile à combustible (2) formée d'au moins une cellule électrochimique comprenant une anode et une cathode séparée l'une de l'autre par une membrane, comportant en outre un circuit de distribution anodique d'hydrogène relié à une ligne fluidique d'évacuation anodique munie d'une vanne de purge commandée à partir d'un signal dit de purge ($Q_{ao}$), et un circuit de distribution cathodique en oxygène, ledit procédé comportant les étapes suivantes :

a) mesure (100), à un instant de mesure ($t_k$), d'un courant électrique (I) de la pile à combustible, d'une tension électrique (V) de la pile à combustible, d'une pression dite anodique ($P^a$) du circuit de distribution anodique, d'une pression dite cathodique ($P^c$) du circuit de distribution cathodique, et d'une température (T) de la pile à combustible ;

b) formation (200) d'un vecteur de commande (U) à partir du signal de purge ($Q_{ao}$) et des mesures du courant électrique (I), de la température (T) et de la pression cathodique ($P^c$) ;

c) formation (300) d'un vecteur de mesure (Y) à partir d'une valeur de résistance ohmique (Rm) de la membrane déduite des mesures du courant électrique (I) et de la tension électrique (V), et à partir de la mesure de la pression anodique ($P^a$) ;

d) calcul (400) d'une évolution temporelle dite non corrigée $(\dot{\hat{X}}_{nc})$, à partir d'une estimation préalable ($\hat{X}$) de l'état (X) et du vecteur de commande (U), sur la base d'une représentation d'état (f) prédéterminée du système électrochimique, l'état (X) étant formé de variables d'état représentatives des quantités d'azote $\left( n_{N_2}^a \right)$ et d'hydrogène $\left( n_{H_2}^a \right)$ à l'anode, et des quantités d'eau à l'anode $\left( n_{H_2O}^a \right)$, à la cathode $\left( n_{H_2O}^c \right)$, et dans la membrane ($\lambda_m$) ;

e) calcul (500) d'un terme correcteur ($\varepsilon$) en mode glissant à partir d'un écart (S) entre le vecteur de mesure (Y) et une estimation dite de mesure ($\hat{Y}$) du vecteur de mesure (Y) obtenue à partir d'une estimation préalable ($\hat{X}$) de l'état (X) ;

f) calcul (700) d'une estimation ($\hat{X}$) dudit état (X) du système électrochimique (1) pour l'instant de mesure ($t_k$), à partir de l'évolution temporelle non corrigée $(\dot{\hat{X}}_{nc})$ et du terme correcteur ($\varepsilon$) ;

g) réitération des étapes a) à f) en incrémentant l'instant de mesure, l'estimation préalable ($\hat{X}$) des étapes d) et e) correspondant alors à l'estimation d'état ($\hat{X}$) calculée à l'itération précédente.

2. Procédé selon la revendication 1, dans lequel l'écart (S) est égal à la différence entre le vecteur de mesure (Y) et l'estimation de mesure ($\hat{Y}$).

3. Procédé selon la revendication 1 ou 2, dans lequel l'estimation de mesure ($\hat{Y}$) est calculée à partir de l'estimation d'état ($\hat{X}$) calculée à l'instant de mesure précédent ($t_{k-1}$), sur la base d'un modèle (h) prédéterminé exprimant une relation entre le vecteur de mesure (Y), l'état (X) et le vecteur de commande (U).

4. Procédé selon l'une quelconque des revendications 1 à 3, dans lequel le terme correcteur ($\varepsilon$) est égal au produit d'un paramètre de gain prédéterminé (K) avec une fonction signe appliquée à l'écart (S).

5. Procédé selon l'une quelconque des revendications 1 à 4, dans lequel le vecteur d'état (X) est défini tel que $X = \left[ n_{N_2}^a ; n_{H_2O}^a ; n_{H_2O}^c ; \lambda_m ; n_{H_2}^a \right]$, le vecteur de commande (U) est défini tel que $U = [Q_{ao}; I; T; P^c]$, et le vecteur de mesure (Y) est défini tel que $Y = [R_m; P^a]$.

6. Procédé selon l'une quelconque des revendications 1 à 5, dans lequel l'étape f) de calcul de l'estimation d'état ($\hat{X}$) comporte une étape de calcul d'un terme dit d'évolution d'estimation d'état $\left( \dot{\hat{X}} \right)$ dont les termes s'écrivent :

$$
\begin{cases}
\dot{\hat{x}}_1 = f_1(\hat{x}, u) - \sigma_1.sign(s_2) \\
\dot{\hat{x}}_2 = f_2(\hat{x}, u) - \sigma_2.sign(s_2) \\
\dot{\hat{x}}_3 = f_3(\hat{x}, u) - \sigma_3.sign(s_1) \\
\dot{\hat{x}}_4 = f_4(\hat{x}, u) - \sigma_4.sign(s_1) \\
\dot{\hat{x}}_5 = f_5(\hat{x}, u) - \sigma_5.sign(s_2)
\end{cases}
$$

où $f_{i=1-5}$ sont les termes de ladite représentation d'état (f), $\sigma_{i=1-5}$ sont les termes d'un paramètre de gain (K), et $s_{i=1,2}$ sont les termes dudit écart (S) définis par $s_1 = y_1 - \hat{y}_1$ et $s_2 = y_2 - \hat{y}_2$, où $y_1$ et $y_2$ sont les termes du vecteur de mesure (Y), et où $\hat{y}_1$ et $\hat{y}_2$ sont les termes de l'estimation de mesure (Ŷ).

7. Procédé selon la revendication 6, dans lequel le paramètre de gain (K) est déterminé de manière à vérifier les fonctions $\dot{V}_1 = s_1 \dot{s}_1 < 0$ et $\dot{V}_2 = s_2 \dot{s}_2 < 0$.

8. Dispositif d'observation (10) d'un état (X) d'un système électrochimique (1) comportant une pile à combustible (2) formée d'au moins une cellule électrochimique comprenant une anode et une cathode séparée l'une de l'autre par une membrane, comportant en outre un circuit de distribution anodique d'hydrogène relié à une ligne fluidique d'évacuation anodique (Le$^a$) munie d'une vanne de purge (4) commandée à partir d'un signal dit de purge ($Q_{ao}$), et un circuit de distribution cathodique en oxygène, le dispositif d'observation comportant :

   • des capteurs (20) adaptés à fournir, pour des instants de mesure ($t_k$) successifs, des mesures mesure d'un courant électrique (I) de la pile à combustible, d'une tension électrique (V) de la pile à combustible, d'une pression dite anodique (P$^a$) du circuit de distribution anodique, d'une pression dite cathodique (P$^c$) du circuit de distribution cathodique, et d'une température (T) de la pile à combustible ;
   • un calculateur (30) configuré pour mettre en oeuvre le procédé d'observation selon l'une quelconque des revendications précédentes, à chaque instant de mesure (tk).

**Patentansprüche**

1. Verfahren zur Beobachtung eines Zustands (X) eines elektrochemischen Systems (1) mit einer Brennstoffzelle (2), die aus mindestens einer elektrochemischen Zelle gebildet ist, die eine Anode und eine Kathode umfasst, die voneinander durch eine Membran getrennt sind, umfassend ferner einen Anoden-Wasserstoffzuführungskreis, der mit einer Anoden-Fluidabführungsleitung verbunden ist, die mit einem Spülventil versehen ist, das ausgehend von einem sogenannten Spülsignal ($Q_{ao}$) betätigt wird, und einen Kathoden-Sauerstoffzuführungskreis, wobei das Verfahren die folgenden Schritte umfasst:

   a) Messen (100), zu einem Messzeitpunkt ($t_k$), eines elektrischen Stroms (I) der Brennstoffzelle, einer elektrischen Spannung (V) der Brennstoffzelle, eines sogenannten Anodendrucks (P$^a$) des Anoden-Zuführungskreises, eines sogenannten Kathodendrucks (P$^c$) des Kathoden-Zuführungskreises und einer Temperatur (T) der Brennstoffzelle;
   b) Bilden (200) eines Stellvektors (U) ausgehend von dem Spülsignal ($Q_{ao}$) und von den Messungen des elektrischen Stroms (I), der Temperatur (T) und des Kathodendrucks (P$^c$);
   c) Bilden (300) eines Messvektors (Y) ausgehend von einem Wert des ohmschen Widerstands (Rm) der Membran, der aus den Messungen des elektrischen Stroms (I) und der elektrischen Spannung (V) und aus der Messung des Anodendrucks (P$^a$) abgeleitet wird;

   d) Berechnen (400) eines sogenannten unkorrigierten zeitlichen Verlaufs $(\dot{\hat{X}}_{nc})$ ausgehend von einer Vorabschätzung ($\hat{X}$) des Zustands (X) und vom Stellvektor (U) auf der Grundlage einer vorherbestimmten Zustandsdarstellung (f) des elektrochemischen Systems, wobei der Zustand (X) aus Zustandsvariablen gebildet ist, die für die Stickstoffmengen $(n_{N_2}^a)$ und Wasserstoffmengen $(n_{H_2}^a)$ an der Anode und für die Wassermengen an der Anode $(n_{H_2O}^a)$, an der Kathode $(n_{H_2O}^c)$ und in der Membran ($\lambda_m$) repräsentativ sind;
   e) Berechnen (500) eines Korrekturterms ($\varepsilon$) im Gleitmodus ausgehend von einer Abweichung (S) zwischen dem Messvektor (Y) und einer sogenannten Messschätzung ($\hat{Y}$) des Messvektors (Y), die ausgehend von einer Vorabschätzung ($\hat{X}$) des Zustands (X) erhalten wird;

f) Berechnen (700) einer Schätzung ($\hat{X}$) des Zustands (X) des elektrochemischen Systems (1) für den Messzeitpunkt ($t_k$) ausgehend von dem unkorrigierten zeitlichen Verlauf $\left(\dot{\hat{X}}_{nc}\right)$ und von dem Korrekturterm ($\varepsilon$);

g) Reiteration der Schritte a) bis f) unter Inkrementierung des Messzeitpunkts, wobei die Vorabschätzung (X) der Schritte d) und e) dann der bei der vorhergehenden Iteration berechneten Zustandsschätzung (X) entspricht.

2. Verfahren nach Anspruch 1, bei dem die Abweichung (S) gleich der Differenz zwischen dem Messvektor (Y) und der Messschätzung ($\hat{Y}$) ist.

3. Verfahren nach Anspruch 1 oder 2, bei dem die Messschätzung ($\hat{Y}$) ausgehend von der zum vorhergehenden Messzeitpunkt ($t_{k-1}$) berechneten Zustandsschätzung ($\hat{X}$) auf der Grundlage eines vorbestimmten Modells (h), das eine Beziehung zwischen dem Messvektor (Y), dem Zustand (X) und dem Stellvektor (U) ausdrückt, berechnet wird.

4. Verfahren nach einem der Ansprüche 1 bis 3, bei dem der Korrekturterm ($\varepsilon$) gleich dem Produkt aus einem vorbestimmten Verstärkungsparameter (K) und einer auf die Abweichung (S) angewandten Vorzeichenfunktion ist.

5. Verfahren nach einem der Ansprüche 1 bis 4, bei dem der Zustandsvektor (X) so definiert ist, dass $X = \left[n_{N_2}^a;\ n_{H_2O}^a;\ n_{H_2O}^c;\ \lambda_m;\ n_{H_2}^a\right]$, der Stellvektor (U) so definiert ist, dass U $=[Q_{ao};I;T;P^c;]$, und der Messvektor (Y) so definiert ist, dass Y $= [R_m;P^a]$.

6. Verfahren nach einem der Ansprüche 1 bis 5, bei dem der Schritt f) des Berechnens der Zustandsschätzung ($\hat{X}$) einen Schritt des Berechnens eines sogenannten Zustandsschätzungsverlaufsterms $\left(\dot{\hat{X}}\right)$ umfasst, dessen Terme sich wie folgt schreiben lassen:

$$
\begin{cases}
\dot{\hat{x}}_1 = f_1\left(\hat{x}, u\right) - \sigma_1 \cdot sign(s_2) \\
\dot{\hat{x}}_2 = f_2\left(\hat{x}, u\right) - \sigma_2 \cdot sign(s_2) \\
\dot{\hat{x}}_3 = f_3\left(\hat{x}, u\right) - \sigma_3 \cdot sign(s_1) \\
\dot{\hat{x}}_4 = f_4\left(\hat{x}, u\right) - \sigma_4 \cdot sign(s_1) \\
\dot{\hat{x}}_5 = f_5\left(\hat{x}, u\right) - \sigma_5 \cdot sign(s_2)
\end{cases}
$$

worin $f_{i=1-5}$ die Terme der Zustandsdarstellung (f) sind, $\sigma_{i=1-5}$ die Terme eines Verstärkungsparameters (K) sind und $s_{i=1,2}$ die Terme der Abweichung (S) sind, die durch $s_1 = y_1 - \hat{y}_1$ und $s_2 = y_2 - \hat{y}_2$ definiert sind, worin $y_1$ und $y_2$ die Terme des Messvektors (Y) sind und worin $\hat{y}1$ und $\hat{y}_2$ die Terme der Messschätzung ($\hat{Y}$) sind.

7. Verfahren nach Anspruch 6, bei dem der Verstärkungsparameter (K) so bestimmt ist, dass die Funktionen $\dot{V}_1 = s_1\dot{s}_1 < 0$ und $\dot{V}_2 = s_2\dot{s}_2 < 0$ verifiziert werden.

8. Vorrichtung zur Beobachtung (10) eines Zustands (X) eines elektrochemischen Systems (1) mit einer Brennstoffzelle (2), die aus mindestens einer elektrochemischen Zelle gebildet ist, die eine Anode und eine Kathode umfasst, die voneinander durch eine Membran getrennt sind, umfassend ferner einen Anoden-Wasserstoffzuführungskreis, der mit einer Anoden-Fluidabführungsleitung (Le$^a$) verbunden ist, die mit einem Spülventil (4) versehen ist, das ausgehend von einem Spülsignal ($Q_{ao}$) betätigt wird, und einen Kathoden-Sauerstoffzuführungskreis, wobei die Beobachtungsvorrichtung umfasst:

• Sensoren (20), die geeignet sind, für aufeinander folgende Messzeitpunkte ($t_k$) Messungen eines elektrischen Stroms (I) der Brennstoffzelle, einer elektrischen Spannung (V) der Brennstoffzelle, eines sogenannten Anodendrucks (P$^a$) des Anoden-Zuführungskreises, eines sogenannten Kathodendrucks (P$^c$) des Kathoden-Zuführungskreises und einer Temperatur (T) der Brennstoffzelle auszugeben;

• einen Rechner (30), der zur Umsetzung eines Beobachtungsverfahrens nach einem der vorgehenden Ansprüche zu jedem Messzeitpunkt ($t_k$) konfiguriert ist.

**Claims**

1.  Method for observing a state (X) of an electrochemical system (1) including a fuel cell (2) that is formed from at least one electrochemical cell comprising an anode and a cathode separated from each other by a membrane, further including an anodic distribution circuit for distributing hydrogen that is linked to an anodic fluid discharge line provided with a purge valve controlled on the basis of a signal, referred to as the purge signal ($Q_{ao}$), and a cathodic distribution circuit for distributing oxygen, said method including the following steps:

    a) measuring (100), at a measurement time ($t_k$), an electric current (I) of the fuel cell, a voltage (V) of the fuel cell, a pressure, referred to as the anodic pressure ($P^a$), of the anodic distribution circuit, a pressure, referred to as the cathodic pressure ($P^c$), of the cathodic distribution circuit, and a temperature (T) of the fuel cell;
    b) forming (200) a control vector (U) on the basis of the purge signal ($Q_{ao}$) and of the measurements of the electric current (I), of the temperature (T) and of the cathodic pressure ($P^c$);
    c) forming (300) a measurement vector (Y) on the basis of an ohmic resistance value (Rm) of the membrane deduced from the measurements of the electric current (I) and of the voltage (V), and on the basis of the measurement of the anodic pressure ($P^a$);

    d) calculating (400) a temporal variation, referred to as a non-corrected temporal variation $\left(\dot{\hat{X}}_{nc}\right)$, on the basis of a prior estimate ($\hat{X}$) of the state (X) and of the control vector (U), based on a predetermined representation (f) of the state of the electrochemical system, the state (X) being formed from state variables that are representative of the amounts of nitrogen $\left(n_{N_2}^a\right)$ and of hydrogen $\left(n_{H_2}^a\right)$ at the anode, and of the amounts of water at the anode $\left(n_{H_2O}^a\right)$, at the cathode $\left(n_{H_2O}^c\right)$, and in the membrane ($\lambda_m$);

    e) calculating (500) a corrective term ($\varepsilon$) in sliding mode on the basis of a difference (S) between the measurement vector (Y) and an estimate, referred to as a measurement estimate ($\hat{Y}$) of the measurement vector (Y) obtained on the basis of a prior estimate ($\hat{X}$) of the state (X);
    f) calculating (700) an estimate ($\hat{X}$) of said state (X) of the electrochemical system (1) for the measurement time (tk), on the basis of the non-corrected temporal variation $\left(\dot{\hat{X}}_{nc}\right)$ and of the corrective term ($\varepsilon$);
    g) reiterating steps a) to f) while incrementing the measurement time, the prior estimate ($\hat{X}$) of steps d) and e) then corresponding to the state estimate ($\hat{X}$) calculated in the preceding iteration.

2.  Method according to Claim 1, in which the difference (S) is equal to the difference between the measurement vector (Y) and the measurement estimate ($\hat{Y}$).

3.  Method according to Claim 1 or 2, in which the measurement estimate ($\hat{Y}$) is calculated on the basis of the state estimate ($\hat{X}$) calculated at the preceding measurement time ($t_{k-1}$), based on a predetermined model (h) expressing a relationship between the measurement vector (Y), the state (X) and the control vector (U).

4.  Method according to any one of Claims 1 to 3, in which the corrective term ($\varepsilon$) is equal to the product of a predetermined gain parameter (K) and a sign function applied to the difference (S).

5.  Method according to any one of Claims 1 to 4, in which the state vector (X) is defined such that

    $$X = \left[\, n_{N_2}^a\,;\, n_{H_2O}^a\,;\, n_{H_2O}^c\,;\, \lambda_m\,;\, n_{H_2}^a\,\right],$$ the control vector (U) is defined such that $U = [Q_{ao};I;T;P^c]$, and the measurement vector (Y) is defined such that $Y = [R_m;P^a]$.

6.  Method according to any one of Claims 1 to 5, in which step f) of calculating the state estimate ($\hat{X}$) includes a step of calculating a term, referred to as a state estimate variation term $\left(\dot{\hat{X}}\right)$, the terms of which are written as:

$$\begin{cases} \dot{\hat{x}}_1 = f_1\left(\hat{x},u\right) - \sigma_1.sign(s_2) \\ \dot{\hat{x}}_2 = f_2\left(\hat{x},u\right) - \sigma_2.sign(s_2) \\ \dot{\hat{x}}_3 = f_3\left(\hat{x},u\right) - \sigma_3.sign(s_1) \\ \dot{\hat{x}}_4 = f_4\left(\hat{x},u\right) - \sigma_4.sign(s_1) \\ \dot{\hat{x}}_5 = f_5\left(\hat{x},u\right) - \sigma_5.sign(s_2) \end{cases}$$

where $f_{i=1\text{-}5}$ are the terms of said state representation (f), $\sigma_{i=1\text{-}5}$ are the terms of a gain parameter (K), and $s_{i=1,2}$ are the terms of said difference (S), which are defined by $s_1 = y_1 - \hat{y}_1$ and $s_2 = y_2 - \hat{y}_2$, where $y_1$ and $y_2$ are the terms of the measurement vector (Y), and where $\hat{y}_1$ and $\hat{y}_2$ are the terms of the measurement estimate ($\hat{Y}$).

7. Method according to Claim 6, in which the gain parameter (K) is determined so as to verify the functions $\dot{V}_1 = s_1\dot{s}_1 < 0$ and $\dot{V}_2 = s_2\dot{s}_2 < 0$.

8. Device (10) for observing a state (X) of an electrochemical system (1) including a fuel cell (2) that is formed from at least one electrochemical cell comprising an anode and a cathode separated from each other by a membrane, further including an anodic distribution circuit for distributing hydrogen that is linked to an anodic fluid discharge line ($Le^a$) that is provided with a purge valve (4) controlled on the basis of a signal, referred to as the purge signal ($Q_{ao}$), and a cathodic distribution circuit for distributing oxygen, the observation device including:

   • sensors (20) that are suitable for delivering, for successive measurement times ($t_k$), measurements measurement of an electric current (I) of the fuel cell, a voltage (V) of the fuel cell, a pressure, referred to as the anodic pressure ($P^a$), of the anodic distribution circuit, a pressure, referred to as the cathodic pressure ($P^c$), of the cathodic distribution circuit, and a temperature (T) of the fuel cell;
   • a computer (30) that is configured to implement the observation method according to any one of the preceding claims, at each measurement time ($t_k$).

**Fig.1**

100

$Q_{ao}(t)$ ; $I(t)$ ; $V(t)$ ; $P^a(t)$ ; $P^c(t)$ ; $T(t)$

200

$U(t)$

300

$Y(t)$

400

$\dot{\hat{X}}_{nc}(t)$

500

$\varepsilon(t)$

600

$\dot{\hat{X}}(t)$

700

$\widehat{X}(t)$

**Fig.2A**

$\widehat{X}(t)$

$Y(t)$

510

$\widehat{Y}(t)$

520

$S(t)$

530

sign(S)

540

$\varepsilon(t) = K.sign(S)$

**Fig.2B**

**Fig.3**

**Fig.4A**

**Fig.4B**

**Fig.4C**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **PIFFARD et al.** Control by state observer of PEMFC anodic purges in dead-end operating mode. *IFAC-PapersOnLine,* 2015, vol. 48-15, 237-243
- optimization of purge cycle for dead-ended anode fuel cell opération. *International Journal of Hydrogen Energy,* 2013, vol. 38, 5092-5105
- **ROBIN et al.** intitulée Development and experimental validation of a PEM fuel cell2D-model to study heterogeneities effects along large-area cell surface. *Int. J. Hydrogen Energy,* 2015, vol. 40, 10211-10230